# EUROPEAN PATENT APPLICATION

(11) **EP 2 354 271 A1**
(43) Date of publication of application: **10.08.2011**
(21) Application number: 10153066.5
(22) Date of filing: 09.02.2010
(51) Int. Cl.: C23C 14/56, C23C 16/44

(54) **Substrate protection device and method**

(71) Applicant: Applied Materials, Inc., Santa Clara, CA 95054 (US)
(72) Inventor: Onken, Peter, 63477 Maintal (DE); Schramm, Sven, 63796 Kahl am Main (DE)
(74) Representative: Zimmermann & Partner

(57) **Abstract**

A protection device (100) is adapted for protecting substrates (302) within a process chamber (300) against deposition material (200) generated by a deposition source (301). The protection device (100) includes a plate (101) adapted for facing the substrate (302) at a side opposing the deposition source (301) and a mesh (102) disposed over the plate (101). The mesh (102) faces the substrate (302) to be processed.

## Description

### TECHNICAL FIELD OF THE INVENTION

Embodiments of the present invention relate to a deposition device for forming thin films onto substrates and in particular relates to a protection device adapted for protecting substrates within a process chamber. Furthermore, embodiments of the present invention relate to a method for depositing a thin film onto a substrate arranged within a process chamber.

### BACKGROUND OF THE INVENTION

The deposition of thin films onto substrates is of increasing importance, e.g. for the production of photovoltaic cells or for forming functional layers on substrates. Deposition of thin films having large areas, e.g. for photovoltaic devices, may be based on processes which include evaporation of a desired deposition material by means of an evaporation apparatus located within a process chamber.

In order to provide high throughput and large area deposition, a high deposition rate is desired which, in case of an evaporation apparatus, is based on a high evaporation rate. In typical evaporation apparatuses, the substrate to be coated is inserted into a process chamber and is arranged, at least during the deposition process, in the vicinity of the evaporation source.

High evaporation rates however, may result in coating of components within the process chamber other than the substrate surface of interest. As a consequence evaporated deposition material, which has been deposited at components or walls in the interior of the process chamber, may reach the substrate, e.g. the deposition material may drop onto the substrate as particles or in liquid form and may cause damage. It is a desire to provide a high-rate deposition process using evaporated deposition material for forming thin films onto substrates with high yield.

### SUMMARY OF THE INVENTION

In light of the above, the present invention provides a protection device adapted for protecting substrates within a process chamber in accordance with independent claim 1 and a method for depositing, within a process chamber, a thin film onto a substrate in accordance with independent claim 10.

According to one embodiment, a protection device adapted for protecting substrates within a process chamber against deposition material generated by a deposition source is provided, the protection device including a plate adapted for facing the substrate at a side opposing the deposition source; and a mesh disposed over the plate, the mesh facing the substrate.

According to a further embodiment, a method is provided for depositing, within a process chamber, a thin film onto a substrate, the method including arranging the substrate in the process chamber; generating deposition material in a gas phase, within the process chamber; depositing, from the gas phase, at least a part of the generated depositing material onto the substrate for forming the thin film; and receiving at least another part of the generated deposition material at a plate having a mesh disposed thereon.

Further advantages, features, aspects and details that can be combined with the above embodiments are evident from the dependent claims, the description and the drawings.

### BRIEF DESCRIPTION OF THE DRAWINGS

So that the manner in which the above recited features of the present invention can be understood in detail, a more particular description of the invention, briefly summarized above, may be had by reference to embodiments. The accompanying drawings relate to embodiments of the invention and are described in the following:
- Figure 1: shows a schematic side-sectional view of a process chamber including a deposition source and a protection device in accordance with a typical embodiment;
- Figure 2: illustrates a plate having a cooling channel and a cooling pipe attached at the cooling channel, as a part of the protection device shown in Fig. 1;
- Figure 3: is a detailed view of a protection device including a plate and a mesh attached at the plate, according to a typical embodiment;
- Figure 4a: is a perspective view of a plate having a mesh etched thereon, shown in Fig. 3;
- Figure 4b: a side sectional view of three plates having a mesh disposed thereon, wherein the individual plates partially overlap in a roofing tile-manner;
- Figure 5: shows a plate having a mesh attached thereon, of a protection device shown in Fig. 1, after the deposition of deposition material has occurred; and
- Figure 6: is a flowchart illustrating a method for depositing, within a process chamber, a thin film onto a substrate.

### DETAILED DESCRIPTION OF THE EMBODIMENTS

Reference will now be made in detail to the various embodiments of the invention, one or more examples of which are illustrated in the figures. Within the following description of the drawings, the same reference numbers refer to the same components. Generally, only the differences with respect to individual embodiments are described. Each example is provided by way of explanation of the invention and is not meant as a limitation of the invention. For example, features illustrated or described as part of one embodiment can be used on or in conjunction with other embodiments to yield yet a further embodiment. It is intended that the present invention includes such modifications and variations.

Embodiments described herein refer inter alia to a deposition system for depositing thin films onto substrates by means of evaporation of a desired deposition material.

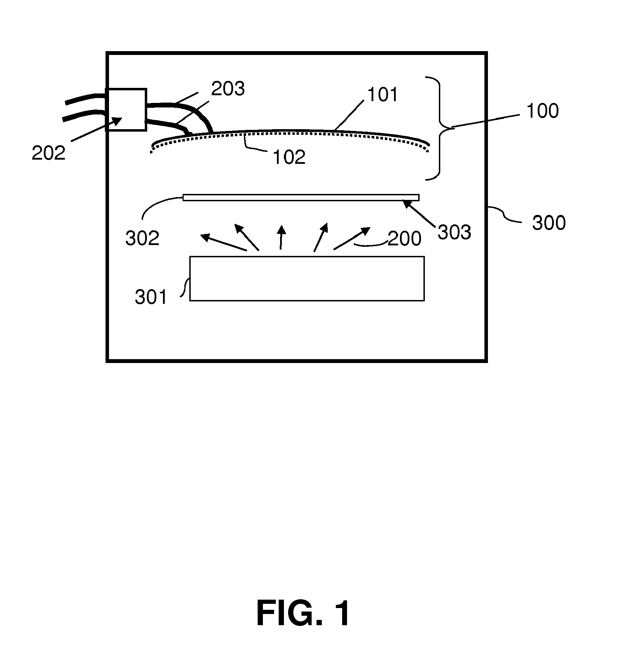

Fig. 1 shows a schematic side-sectional view of a process chamber 300 including a deposition source 301 and a protection device 100 in accordance with a typical embodiment. For a deposition process, an evaporator may be used as the deposition source 301. In addition to that, or alternatively, other deposition sources such as deposition sources used for physical vapour deposition (PVD) and/or chemical vapour deposition (CVD) may be employed. Embodiments described herein above may be applied to thin-film vapor deposition on different substrates 302 such as substrates for solar panels.

As illustrated in Fig. 1, the deposition source 301 is arranged within the process chamber 300 where a substrate 302 to be coated may be inserted. The deposition material 200 to be deposited is melted and evaporated by heating the respective material within the deposition source 301. Heating can be conducted by means of an electrical power source (not shown in Fig. 1), e.g. by flowing a heating current through the material to be deposited.

Evaporated deposition material 200 is directed towards a surface 303 to be coated, i.e. a front surface of the substrate 302. In particular, if high deposition rates are desired, a large amount of evaporated deposition material 200 is generated within the process chamber 300. Thus, deposition material 200 may not only settle at the substrate surface 303 to be coated but also on other components in the interior of the process chamber 300 and at the inner walls of the process chamber 300.

According to a typical embodiment shown in Fig. 1, the protection device 100 is provided for protecting the substrate 302 within the process chamber 300 against evaporated deposition material 200, e.g. against deposition material which has been transferred from gas phase into a liquid or solid phase and which drops or falls down from other components in the interior of the process chamber 300 or from inner walls of the process chamber 300.

The protection device 100 includes a plate 101 which may be designed as a shielding plate arranged at a side of the substrate 302 opposing the deposition source 301. Furthermore, the protection device 100 includes a mesh 102, which may be provided as a wire mesh. The mesh 102 is disposed over the plate 101 at at least portions of the surface of the plate 101. According to a typical embodiment which may be combined with other embodiments described herein, the mesh 102 faces the substrate 302.

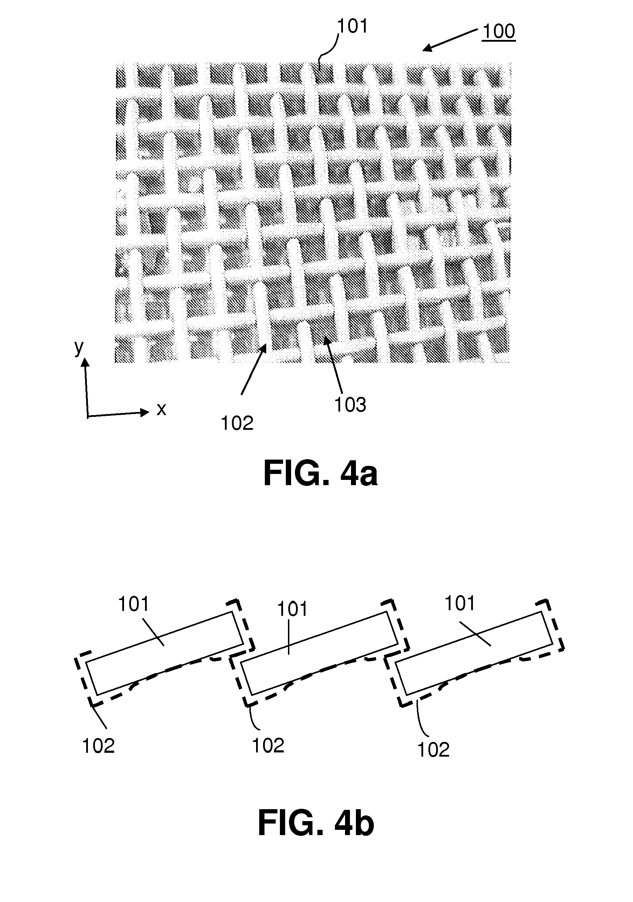

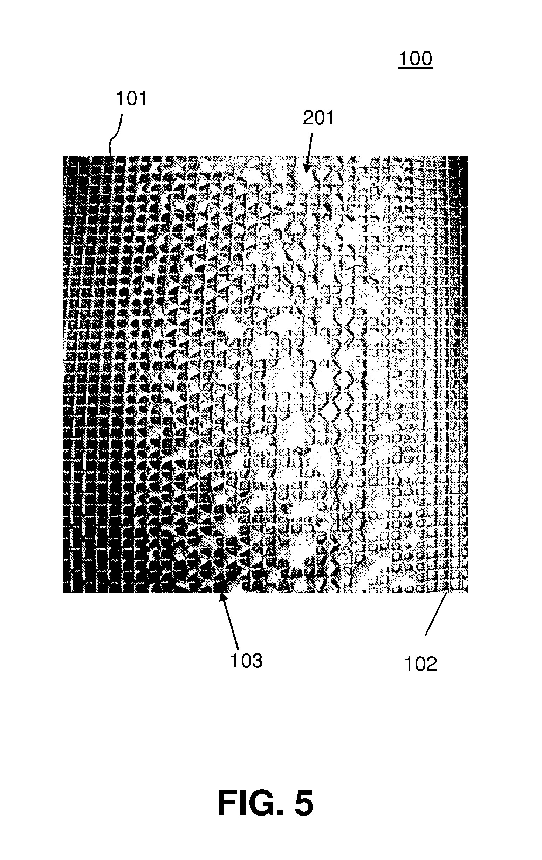

At least a part of the generated, evaporated deposition material 200 ("film-forming" deposition material) is deposited onto the front surface 303 (the substrate surface to be coated) for forming a thin film onto the substrate 302. In addition to that, at least another part of the generated evaporated deposition material 200 ("excess" deposition material) is received at the plate 101 and the mesh 102, respectively, of the protection device 100. As will be explained with respect to Figs. 4 and 5 herein below, the "excess" deposition material may be retained at at least one of the plate 101 and the mesh 102, e.g. as particles and/or in liquid form.

It is noted here that the term "film-forming" deposition material relates to the part of deposition material 200 which is deposited, from the deposition source 301, directly onto the front surface 303 of the substrate 302. The term "excess" deposition material relates to another part of the deposition material 200 which is not deposited onto the front surface 303 of the substrate 302 but onto other components within the process chamber 300 or onto inner walls of the process chamber 300.

Excess deposition material, for example, may be deposited onto any components within the process chamber 300 and/or inner walls of the process chamber 300. Thus, depending on the arrangement of the substrate 302 with respect to the deposition source 301, excess deposition material may fall e.g. as particles and/or may drop, e.g. in liquid form, from interior components onto the substrate 302, e.g. on a backside of the substrate facing the front surface 303. Thus, the excess deposition material may cause damage to the substrate 302 and the yield of the deposition process carried out in the process chamber 300 is reduced.

According to another modification thereof, a cooling device 202 may be provided for cooling the protection device 100, in particular for cooling the plate 101. Cooling of the plate 101 accelerates a transfer of the excess deposition material 200 which is not deposited onto the front surface 303 of the substrate 302, from the gas phase to a solid and/or a liquid phase. Thus, the excess deposition material 200 may be held at the plate 101 and/or the mesh 102, respectively, as particles or in liquid form.

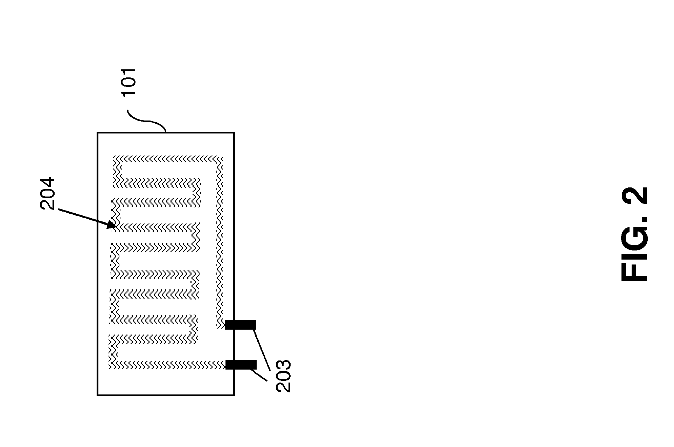

The cooling device 202 may include cooling channels within the plate 101, as will be described herein below with respect to Fig. 2. Furthermore, the cooling device 202 includes at least one cooling pipe 203 in fluid communication with cooling channels 204 provided in the plate 101. According to another typical embodiment which can be combined with other embodiments described herein, a cooling pipe may be attached at and in thermal contact with the plate 101. For example, the cooling pipe may be attached at a side of the plate 101 opposing the side where the mesh 102 is attached.

Due to the effect of cooling of the plate 101 and/or the mesh 102, an adhesion of the excess deposition material 200 is increased such that high deposition rates for depositing the film-forming deposition material 200 onto the front surface 303 of the substrate 302 for forming the thin film may be increased without damaging the substrate 302 by the excess deposition material 200, which may drop down from components within the interior of the process chamber 300 or from inner walls of the process chamber 300.

If high deposition rates are realized within the process chamber 300, large area substrates may be coated by thin films, the deposition process being carried out at high throughput. On the other hand, if high deposition rates are realized within the process chamber 300, the amount of excess deposition material is increased as well.

According to a typical embodiment, excess deposition material may be held at the protection device 100 arranged within the process chamber 300. A protection of the substrate 302 is provided by retaining a larger amount of excess deposition material at locations distant from the substrate 302 as compared to deposition arrangements without protection device (where excess deposition material may settle at interior walls or components and may fall off easily). The larger amount of excess deposition material may be retained at the protection device 100. If the plate (shielding plate) 101 is arranged in such a way that a major part of the excess deposition material is retained by the protection device 100, damage to the substrate 302 due to the effect of dropping of excess deposition material from components within the interior of the process chamber 300 is decreased.

Thus, the protection device 100 is designed in such a way that a good adhesion of excess deposition material deposited at the protection device 100 is provided. In this way, a high deposition rate provided by the deposition source 301 within the process chamber 300 may be achieved.

Although not shown in Fig. 1, the deposition source 301 may be provided as at least one of an evaporation apparatus, a sputter device, a CVD source and a PVD source. The deposition material 200 evaporated from the deposition source 301 may include any material selected from the group of Al, Cu, CuNi, Sn, Ag, and any combination thereof. Any excess deposition material 200 evaporated from the deposition source 301 may be held at the plate 101 and/or the mesh 102, respectively, as particles or in liquid form.

The protection device 100 according to a typical embodiment, which can be combined with other embodiments described herein, is adapted for protecting substrates 302 within the process chamber 300 against deposition material generated by the deposition source 301. The plate 101 provided as a shielding plate faces the substrate 302 at a side opposing the deposition source 301.

The mesh 102 is disposed over at least portions of the plate 101 such that the mesh 102 faces the substrate 302. The shielding plate 101 may include a temperature control means adapted for controlling the temperature of the plate 101. During a deposition process, e.g. by evaporating deposition material 200, the plate 101 is arranged in the vicinity of the deposition source 301, the plate 101 having attached thereon the mesh 102, wherein the mesh 102 faces the deposition source 301.

High deposition rates may be obtained using the protection device 100 according to typical embodiments described herein. For example, the deposition material 200 may be generated at an evaporation rate, which typically is in a range from 0.01 µm x m/min to 30 µm x m/min, and typically amounts to approximately 5.0 µm x m/min.

In addition to that, or alternatively, the plate 101 may include a heating unit adapted for heating the plate 101. Thus, a temperature of the plate 101 may be adjusted in a wide range such that a good adhesion of excess deposition material at at least one of the plate 101 and the mesh 102 is achieved. The deposition process, which is carried out in the process chamber 300 may be used, e.g. for the coating of substrates for solar wafers or the like. Thereby, a typical substrate size may be in a range from 100 mm x 100 mm to 2850 mm x 3050 mm, such as for example 2600 mm x 2200 mm. Even for large area substrates 302 (wafers), a protection of the substrates 302 by retaining excess deposition material at the plate-mesh 101-102 arrangement may be achieved.

Fig. 2 is a schematic view of a plate 101 including a cooling unit. The cooling unit includes a cooling channel 201 provided integrally within the plate 101. For example, the cooling channel 204 is provided in the interior of the plate 101 and has a meander-shaped structure. At least two cooling pipes 203 are attached at the ends of the cooling channel, such that a cooling fluid may flow via the cooling pipe 203 through the cooling channel 204. According to another typical embodiment, which can be combined with other embodiments described herein, a cooling pipe may be attached at and in thermal contact with the plate 101. For example, the cooling pipe may be attached at a side of the plate 101 opposing the side where the mesh 102 is attached.

It is noted here that the mesh 102 described herein above is not shown in Fig. 2. The temperature of the plate 101 may be controlled by flowing the cooling fluid through the cooling channel 204 provided in the plate 101. Furthermore, according to an alternative embodiment, which may be combined with other embodiments described herein, the temperature of the plate 101 may be controlled by heating the plate 101 by an appropriate flow of a heating fluid through the cooling channel 204 of the cooling plate 101.

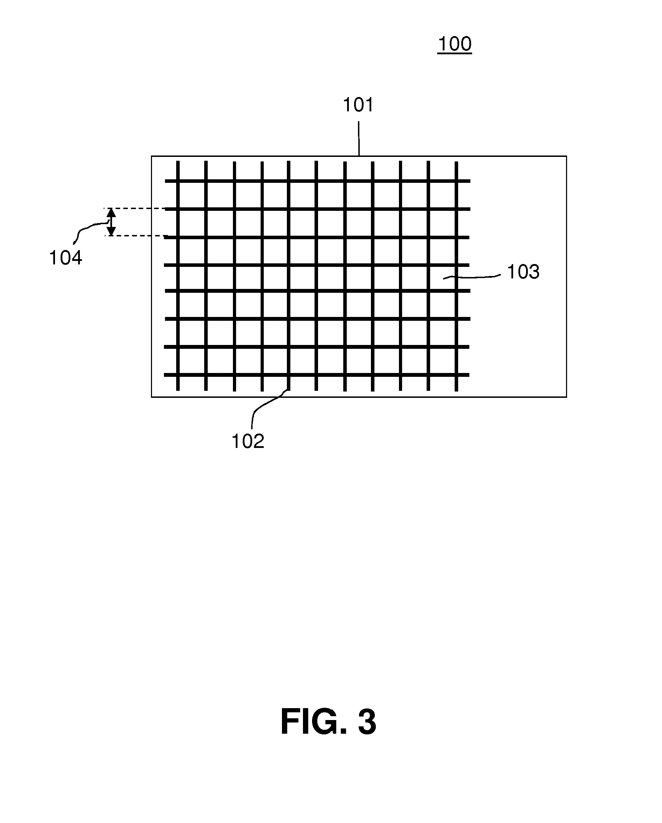

Fig. 3 is a detailed view of a protection device 100 including a plate 101 and a mesh 102 attached to the plate 101, according to a typical embodiment.

The protection device 100 includes the plate 101 and has the mesh 102 disposed over at least portions of the plate 101. The mesh 102 faces the substrate (not shown in Fig. 3). The mesh 102 may have a predetermined mesh spacing 104 such that a number of recesses 103 of predetermined sizes are obtained. Within the recesses, and at the mesh 102 and the plate 101, respectively, excess deposition material evaporated from the deposition source 301 may be retained, e.g. as particles or in liquid form.

In accordance with yet another typical embodiment, which may be combined with other embodiments described herein, the plate 101 may have a corrugated surface in order to enhance a retainment of excess deposition material evaporated from the deposition source 301. According to an optional modification thereof, an interval of the corrugations may correspond to the mesh spacing 104 such that even deeper recesses are obtained which may receive excess deposition material.

The plate 101 of the protection device 100 may include a material which is selected from the group consisting of steel, copper, aluminium, bronze, an alloy and any combination thereof.

The mesh 102 may be designed such that the mesh spacing 104 is in a range from 1 mm to 5 cm, and typically amounts to approximately 1 cm.

According to a modification thereof, the plate may not be fully covered by the mesh 102, i.e. the mesh 102 may be disposed at predetermined portions of the plate 101, wherein remaining portions of the plate 101 may not be covered by the mesh. Alternatively, the mesh 102 may be provided at the plate 101 such that the plate 101 is fully covered by the mesh 102. According to yet a further embodiment which may be combined with other embodiments described herein, the plate 101 and the mesh 102 may be formed as an integral unit, i.e. the integral unit may include the plate 101 fully covered by the mesh 102 or the plate 101 not fully covered by the mesh 102.

At least one of the plate 101 and the mesh 102 may be formed of a heat-resistant material. Specifically, the plate 101 may include a material which is selected from the group consisting of steel, copper, aluminium, brass, an alloy and any combination thereof. Furthermore, the mesh 102 may include a material which is selected from the group consisting of steel, copper, aluminium, brass, an alloy and any combination thereof.

Fig. 4a is an elevated perspective view showing a protection device in accordance with a typical embodiment. As can be seen in Fig. 4a, a wire mesh 102 is arranged at a side of the plate 101. Thus, a number of recesses 103 are formed where excess deposition material 200 evaporated by the deposition source 301 may be retained.

The mesh 102 may be a plaited mesh, wherein the area covered by the mesh 102 may coincide with the area of the plate 101 or may be less than the area of the plate 101 such that portions of the plate 101 are not covered by the mesh 102.

According to yet a further typical embodiment which may be combined with other embodiments described herein, the mesh spacing 104 may vary along the plate in an x-direction and/or in a y-direction shown in Fig. 4a. Thus different recess sizes in the protection device 100 may be provided, wherein the recess sizes may be adapted to an expected amount of deposition material to be received by the plate-mesh 101, 102 structure. The shape of the recesses 103 may be a square as shown in Fig. 4a, but other shapes may also be applied. In addition to that, or alternatively, the mesh may be formed by plated wires. The mesh 102 may be bonded at the plate 101 at the side of the plate 101 facing the substrate 302. An issue when designing the protection device 100 is the support of the mesh 102 at the plate 101. In order to avoid overheating of the mesh 102 the mesh is attached as close as possible at the plate, i.e. a good thermal contact is provided. In order to achieve a high throughput of substrates 300 to be coated the evaporation rate at the deposition source 301 is set at high values. The mesh 102 may be heated by condensation heat such that the protection device may represent an additional heat source for the substrate 301. In case the mesh 102 has been heated up to excessive temperatures, e.g. due to a long duration of the deposition process and/or interruption of substrate supply, evaporation times and excess deposition material may drop off the mesh 102. Thus the mesh 102 is closely attached at the plate 101, e.g. by means of additional fixing points which may be provided in the form of bolt heads. It is noted here that these fixing points may be designed such that they are not acting as additional particle sources. The fixing points may be arranged such that a sufficient thermal contact between the mesh 102 and the respective plate 101 is provided.

Fig. 4b is a side sectional view of three plates 101 having meshes 102 disposed thereon. As illustrated in Fig. 4b an individual mesh 102 has a curved shape wherein a convex side of the mesh 102 may touch the plate 101 at the side of the plate 101 facing the substrate 302. The curved shape of the mesh 102 provides a mechanical pre-stress for an increased thermal contact of the mesh 102 with the surface of the respective plate 101. An increased thermal contact between mesh 102 and plate surface provides an effective cooling of the mesh 102, and thus excess deposition material may be held at the protection device 100 in a more reliable manner. Furthermore, the individual meshes 102 may be shaped such that they can be drawn over the respective plate 101 from a side of the plate 101. Thus an easy installation of an individual mesh 102 at the corresponding plate 101 may be provided. In addition to that the individual plates 101 having the meshes 102 disposed thereon may partially overlap in a roofing tile-manner as illustrated in the side sectional view of Fig. 4b. In this way a quasi-continuous coating of excess deposition material at meshes 102 belonging to adjacent plates 101 without rated break point within the deposited coating may be achieved.

Fig. 5 depicts a protection device 100 which has been subjected to excess evaporation material 200 evaporated by the deposition source 301. As shown in Fig. 5, portions of the protection device 100 are coated by excess deposition material, i.e. retained deposition material 201 can be observed in specific regions of the plate-mesh 101, 102 arrangement, e.g. in liquid or solid form.

Other recesses 103 are not coated by deposition material 200 and are still able to receive excess deposition material. Thus, a flaking-down or peeling-off of deposition material is avoided or at least reduced because the excess deposition material is retained by the wire-mesh 101, 102 structure.

The mesh spacing 104 (see Fig. 3) is designed such that a dropping-down of deposition material is reduced. The received part of deposition material 200, i.e. the excess deposition material is retained at at least one of the plate 101 and the mesh 102 as particles or in liquid form. Evaporation rates which may be provided within the process chamber 300 thus may be increased without damaging the substrate by drop-down of excess deposition material.

Using the protection device described herein, dynamic deposition rates ranging from 0.01 µm x m/min to 50 µm x m/min, and typically of approximately 5 µm x m/min, may be provided within the process chamber 300 without substrate damage.

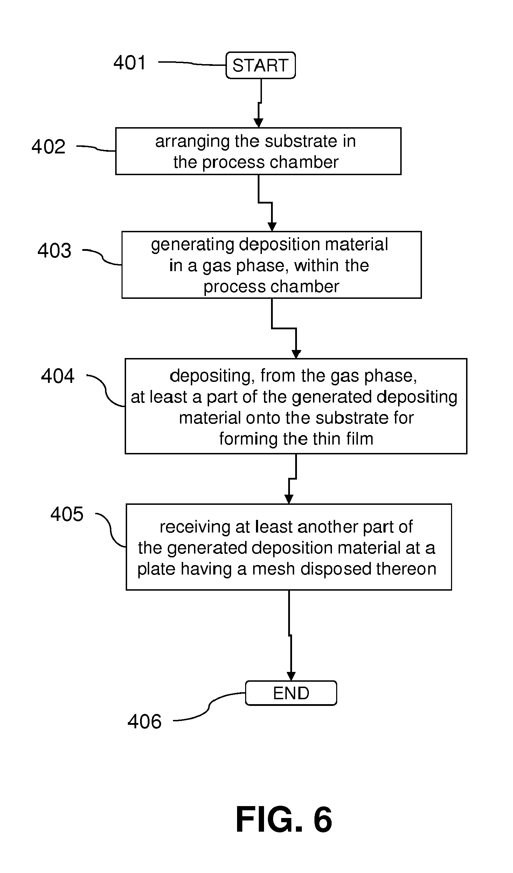

Fig. 6 is a flowchart illustrating a method for depositing a thin film onto a substrate 302 within a process chamber 300. The procedure starts at a block 401. At a block 402, the substrate 302 is arranged in the process chamber 300. Then deposition material 200 is generated in a gas phase within the process chamber 300 (block 403).

In a block 404 shown in Fig. 6, generated deposition material, i.e. film-forming deposition material 200, is deposited onto the substrate 302 for forming the thin film. At least another part of the generated deposition material 200, i.e. the excess deposition material, is received at the plate 101 having the mesh 102 disposed thereon (block 405). The procedure is ended at a block 406.

In light of the above, a plurality of embodiments have been described. For example, according to one embodiment, a protection device adapted for protecting substrates within a process chamber against deposition material generated by a deposition source is provided, the protection device including a plate adapted for facing the substrate at a side opposing the deposition source; and a mesh disposed over the plate, the mesh facing the substrate. According to an optional modification thereof, the plate includes a temperature control means adapted for controlling the temperature of the plate. The temperature control means may include cooling channels adapted for receiving a cooling fluid. According to yet further additional or alternative modifications the mesh is formed by plated wires. Moreover, a mesh spacing of the mesh is in a range from 1 mm to 5 cm, and typically amounts to approximately 1 cm. According to an optional modification thereof, the mesh spacing varies along the plate. According to yet further embodiments, which can be combined with any of the other embodiments and modifications above, the mesh is disposed at predetermined portions of the plate, wherein remaining portions of the plate are not covered by the mesh. In addition to that, or alternatively, the mesh may be bonded at the plate at the side of the plate facing the substrate. According to yet further embodiments, which can be combined with any of the other embodiments and modifications above, the plate and the mesh are formed as an integral unit. According to yet further additional or alternative modifications at least one of the plate and the wire mesh are formed of a heat resistant material. Furthermore, the plate may include a material which is selected from the group consisting of steel, copper, aluminum, brass, an alloy and any combination thereof. Furthermore, the wire mesh may include a material which is selected from the group consisting of steel, copper, aluminum, brass, an alloy and any combination thereof. According to an optional modification thereof, the plate includes a heating unit adapted for heating the plate. According to another embodiment, a method is provided for depositing, within a process chamber, a thin film onto a substrate, the method including arranging the substrate in the process chamber; generating deposition material in a gas phase, within the process chamber; depositing, from the gas phase, at least a part of the generated depositing material onto the substrate for forming the thin film; and receiving at least another part of the generated deposition material at a plate having a mesh disposed thereon. According to yet further additional or alternative modifications thereof the method may further include arranging the plate in the vicinity of a deposition source generating the deposition material, the mesh facing the deposition source. According to yet further embodiments, which can be combined with any of the other embodiments and modifications above, the deposition material is generated at an evaporation rate which is in a range from 0.01 µm x m/min to 30 µm x m/min, and typically amounts to approximately 5.0 µm x m/min. Moreover, the received part of the generated deposition material is retained at at least one of the plate and the mesh as particles or in liquid form. In addition to that, the temperature of the plate may be controlled using a temperature control means. According to yet further additional or alternative modifications the temperature of the plate may be controlled by flowing a cooling fluid through cooling channels provided in the plate. According to yet further embodiments, which can be combined with any of the other embodiments and modifications above, the temperature of the plate is controlled by heating the plate by means of a heating unit.

While the foregoing is directed to embodiments of the invention, other and further embodiments of the invention may be devised without departing from the basic scope thereof and the scope thereof is determined by the claims that follow.

## Claims

1. A protection device adapted for protecting substrates within a process chamber against deposition material generated by a deposition source, the protection device comprising:
a plate adapted for facing the substrate at a side opposing the deposition source; and
a mesh disposed over the plate, the mesh facing the substrate.

2. The protection device in accordance with claim 1, wherein the plate comprises a temperature control means adapted for controlling the temperature of the plate.

3. The protection device in accordance with claim 1 or 2, wherein the temperature control means comprises cooling channels adapted for receiving a cooling fluid.

4. The protection device in accordance with any one of the preceding claims, wherein the mesh is formed by plated wires.

5. The protection device in accordance with any one of the preceding claims, wherein a mesh spacing of the mesh is in a range from 1 mm to 5 cm and typically amounts to approximately 1 cm.

6. The protection device in accordance with claim 5, wherein the mesh spacing varies along the plate.

7. The protection device in accordance with any one of the preceding claims, wherein the mesh is disposed at predetermined portions of the plate, wherein remaining portions of the plate are not covered by the mesh.

8. The protection device in accordance with any one of the preceding claims, wherein the mesh is bonded at the plate at the side of the plate facing the substrate.

9. The protection device in accordance with any one of the preceding claims, wherein the plate and the mesh are formed as an integral unit.

10. A method for depositing, within a process chamber, a thin film onto a substrate, the method comprising:
arranging the substrate in the process chamber;
generating deposition material in a gas phase, within the process chamber;
depositing, from the gas phase, at least a part of the generated depositing material onto the substrate for forming the thin film; and
receiving at least another part of the generated deposition material at a plate having a mesh disposed thereon.

11. The method in accordance with claim 10, further comprising arranging the plate in the vicinity of a deposition source generating the deposition material, the mesh facing the deposition source.

12. The method in accordance with claim 10 or 11, wherein the deposition material is generated at an evaporation rate which is in a range from 0.01 µm x m/min to 30 µm x m/min, and typically amounts to approximately 5.0 µm x m/min.

13. The method in accordance with any one of the claims 10 to 12, wherein the received part of the generated deposition material is retained at at least one of the plate and the mesh in liquid form.

14. The method in accordance with any one of the claims 10 to 13, wherein the temperature of the plate is controlled using a temperature control means.

15. The method in accordance with any one of the claims 10 to 14, wherein the temperature of the plate is controlled by flowing a cooling fluid through cooling channels provided in the plate.
